# DEMANDE DE BREVET EUROPEEN

(11) **EP 3 872 839 A1**
(43) Date de publication de la demande: **01.09.2021**
(21) Numéro de dépôt: 21170134.7
(22) Date de dépôt: 17.09.2015
(51) Int. Cl.: H01L 21/20, H01L 21/762

(54) **STRUCTURE POUR APPLICATIONS RADIOFREQUENCES**

(30) Priorité: 04.12.2014 FR 1402801
(62) Demande divisionnaire de: 15788467.7
(71) Demandeur: SOITEC, 38190 Bernin (FR)
(72) Inventeur: KONONCHUK, Oleg, 38570 MONTGOYE (FR); LANDRU, Didier, 38190 Le Champ-pres-froges (FR); FIGUET, Christophe, 38920 CROLLES (FR)
(74) Mandataire: IP Trust

(57) **Abrégé**

Structure (1) pour des applications radiofréquences comprenant :
• un substrat support (2) semi-conducteur ;
• une couche de piégeage (3) disposée sur le substrat support (2) ;
la couche de piégeage (3) étant caractérisée en ce qu'elle comprend une densité de défauts supérieure à une densité de défauts prédéterminée ; la densité de défauts prédéterminée est la densité de défauts au-delà de laquelle la résistivité électrique de la couche de piégeage (3) est supérieure ou égale à 10kohm.cm sur une gamme de température [-20°C ; +120°C].

## Description

### DOMAINE DE L'INVENTION

La présente invention concerne le domaine des dispositifs radiofréquences intégrés.

### ARRIERE PLAN TECHNOLOGIQUE DE L'INVENTION

Les dispositifs intégrés sont usuellement élaborés sur des substrats en forme de plaquettes, qui servent principalement de support à leur fabrication. Toutefois, l'accroissement du degré d'intégration et des performances attendues de ces dispositifs entraine un couplage de plus en plus important entre leurs performances et les caractéristiques du substrat sur lequel ils sont formés. C'est particulièrement le cas des dispositifs radiofréquence (RF), traitant des signaux dont la fréquence est comprise entre environ 3kHz et 300GHz, qui trouvent notamment leur application dans le domaine des télécommunications (téléphonie cellulaire, Wi-Fi, Bluetooth...).

A titre d'exemple de couplage dispositif/substrat, les champs électromagnétiques, issus des signaux hautes fréquences se propageant dans les dispositifs, pénètrent dans la profondeur du substrat et interagissent avec les éventuels porteurs de charge qui s'y trouvent. Il s'en suit des problèmes de distorsion non linéaire du signal (harmoniques), une consommation inutile d'une partie de l'énergie du signal par perte d'insertion et des influences possibles entre composants.

Ainsi, les dispositifs RF présentent des caractéristiques régies à la fois par leurs architectures et procédés d'élaboration et par la capacité du substrat sur lequel ils sont fabriqués à limiter les pertes d'insertion, les diaphonies entre dispositifs voisins, et les phénomènes de distorsion non-linéaire générant des harmoniques.

Avec l'explosion de la demande de données, créée par les applications « multimédia », l'évolution des normes de la téléphonie mobile (2G, 3G, LTE, LTE-A...) impose également des spécifications de plus en plus exigeantes aux composants RF. Les performances RF de ces composants doivent être garanties typiquement entre -20°C et +120°C, ce qui sous tend que les propriétés électriques du substrat soient stables dans cette gamme de température.

Les dispositifs radiofréquences, tels que des commutateurs et adaptateurs d'antennes ainsi que des amplificateurs de puissance, peuvent être élaborés sur différents types de substrats.

On connaît par exemple les substrats silicium sur saphir, communément appelés SOS (pour « silicon on sapphire » selon l'appellation anglo-saxonne), qui font bénéficier les composants, élaborés selon des technologies micro-électroniques dans la couche superficielle de silicium, des propriétés isolantes du substrat de saphir, indépendantes de la température. Par exemple, les commutateurs d'antenne et amplificateurs de puissance fabriqués sur ce type de substrat présentent de très bons facteurs de mérite mais sont principalement utilisés pour des applications de niche du fait du coût global de la solution.

On connaît également les substrats à base de silicium haute résistivité comprenant un substrat support, une couche de piégeage disposée sur le substrat support, une couche diélectrique disposée sur la couche de piégeage, et une couche de semi-conducteur disposée sur la couche diélectrique. Le substrat support présente habituellement une résistivité supérieure à 1 kOhm.cm. La couche de piégeage peut comprendre du silicium poly-cristallin non dopé. La combinaison d'un substrat support haute résistivité et d'une couche de piégeage selon l'état de l'art permet de réduire le couplage dispositif/substrat cité précédemment, et ainsi d'assurer de bonnes performances des dispositifs RF. A cet égard, l'homme du métier trouvera une revue des performances des dispositifs RF fabriqués sur le substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing.

Néanmoins, ces substrats ne satisfont pas les spécifications les plus exigeantes : par exemple, lorsqu'un échauffement local au-delà d'environ 80°C se produit, la résistivité de ces substrats chute compte tenu de la génération de porteurs thermiques dans le substrat et le couplage dispositif/substrat redevient un contributeur majeur d'atténuation et de distorsion du signal et d'influence parasite entre composants. On observe également des dégradations de la performance lorsque la température descend en-dessous de 0°C.

### OBJET DE L'INVENTION

Un objet de l'invention est donc de proposer une structure adaptée pour les applications radiofréquences, remédiant aux inconvénients de l'art antérieur. Un objet de l'invention est de proposer une structure intégrée assurant les performances radiofréquences, notamment dans la gamme de températures d'utilisation.

### BREVE DESCRIPTION DE L'INVENTION

L'invention concerne une structure pour des applications radiofréquences comprenant :
- un substrat support semi-conducteur ;
- une couche de piégeage disposée sur le substrat support.

Selon l'invention, la couche de piégeage est remarquable en ce qu'elle comprend une densité de défauts supérieure à une densité de défauts prédéterminée ; la densité de défauts prédéterminée est la densité de défauts pour laquelle la résistivité électrique de la couche de piégeage est supérieure ou égale à 10kohm.cm sur une gamme de température [-20°C ; +120°C].

La structure pour applications radiofréquences selon l'invention présente ainsi des propriétés électriques stables en température, assurant une bonne stabilité et répétabilité des performances RF dans la gamme de température d'utilisation.

Selon des caractéristiques avantageuses de l'invention, prises seules ou en combinaison :
- la couche de piégeage présente une résistivité, à 20 °C, supérieure à 10 kOhm.cm, de préférence supérieure à 50 kOhm.cm ;
- la différence de coefficient d'expansion thermique de la couche de piégeage et du substrat support est inférieure à 5 ppm/K entre 100°C et 1200°C ;
- la couche de piégeage comprend des microstructures de taille inférieure à 20 nm, de préférence inférieure à 10 nm ;
- la couche de piégeage comprend un matériau poreux ou poly cristallin ;
- la couche de piégeage comprend du silicium poly-cristallin comprenant 1 à 20 % de carbone ;
- l'épaisseur de la couche de piégeage est comprise entre 10 et 50 µm, de préférence entre 20 et 30 µm ;
- le substrat support comprend au moins un des matériaux sélectionné dans le groupe suivant: silicium, silicium germanium, carbure de silicium ;
- la résistivité du substrat support est comprise entre 10 et 2000 Ohm.cm.

Selon d'autres caractéristiques avantageuses de l'invention, prises seules ou en combinaison :
- une couche active est disposée sur la couche de piégeage ;
- la couche active est reportée sur la couche de piégeage par collage direct ;
- la couche active est formée à partir d'un matériau semi-conducteur ;
- la couche active est formée à partir d'un matériau piézoélectrique ;
- l'épaisseur de la couche active est comprise entre 10 nm et 50 µm ;
- une couche diélectrique est disposée entre la couche de piégeage et la couche active ;
- la couche diélectrique est reportée sur la couche de piégeage par collage direct ;
- la couche diélectrique est comprise entre 10 nm et 6 µm.

Selon d'autres caractéristiques avantageuses de l'invention, prises seules ou en combinaison, au moins un dispositif microélectronique est présent sur ou dans la couche active :
- le dispositif microélectronique est un circuit de commutation ou un circuit d'adaptation d'antenne ou encore un circuit d'amplification de puissance radiofréquences ;
- le dispositif microélectronique comprend une pluralité de composants actifs et une pluralité de composants passifs ;
- le dispositif microélectronique comprend au moins un élément de commande et un élément de commutation MEMS consistant en un micro-commutateur à contact ohmique ou en un micro-commutateur capacitif ;
- le dispositif microélectronique est un filtre radiofréquence fonctionnant par propagation d'ondes acoustiques de volume ou de surface.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 représente une structure pour applications radiofréquences conforme à l'invention, comportant un substrat et une couche de piégeage ;
- la figure 2 présente des courbes comparatives de la résistivité de structures selon l'état de l'art et d'une structure conforme à l'invention ;
- les figures 3a et 3b représentent respectivement une structure pour applications radiofréquences conforme à l'invention, comportant en outre une couche active ;
- les figures 4a et 4b représentent respectivement une structure pour applications radiofréquences conforme à l'invention, comportant en outre un dispositif microélectronique.

### DESCRIPTION DETAILLEE DE L'INVENTION

La structure 1,1',11 pour applications radiofréquences selon l'invention comprend un substrat support 2 semi-conducteur. Le substrat support 2 peut être constitué de matériaux utilisés habituellement dans l'industrie de la microélectronique, de l'optique, de l'opto-électronique, du photovoltaïque. Notamment, le substrat support 2 peut comprendre au moins un matériau sélectionné dans le groupe suivant : silicium, silicium germanium, carbure de silicium, etc. La résistivité du substrat support pourra être comprise entre 1 et 10000ohm.cm ; elle est avantageusement comprise entre 10 et 2000ohm.cm.

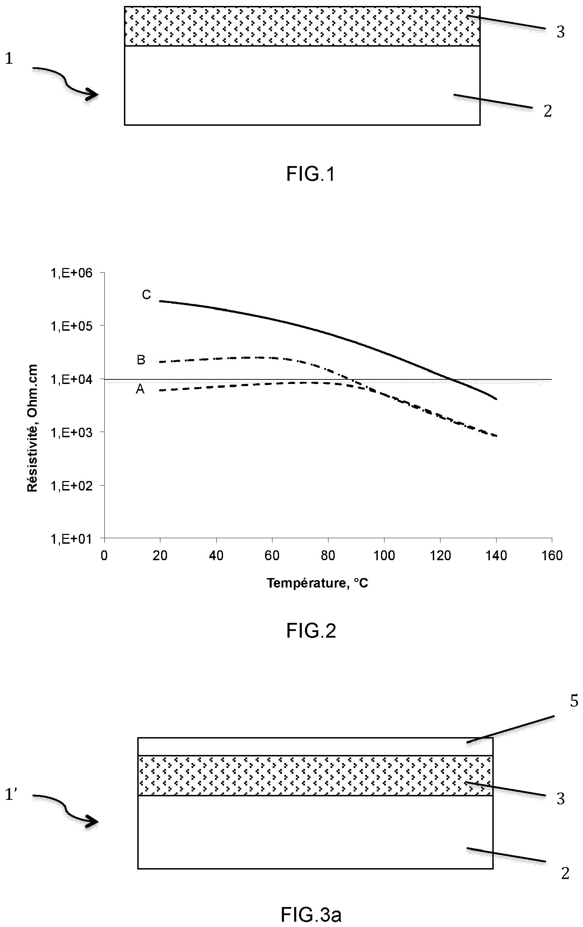

La structure 1,1',11 pour applications radiofréquences comprend également une couche de piégeage 3 disposée sur le substrat support 2, comme représenté sur les figures 1,3 et 4. La couche de piégeage 3 comprend une densité de défauts supérieure à une densité de défauts prédéterminée ; la densité de défauts prédéterminée est la densité de défauts pour laquelle la résistivité électrique de la couche de piégeage est supérieure ou égale à 10kohm.cm sur la gamme de température [-20°C ; +120°C].

La détermination du nombre de défauts ou de la densité de défauts peut être réalisée par différentes techniques dont la microscopie électronique à transmission (TEM selon la terminologie anglo-saxonne). La densité de défauts ainsi connue, la résistivité électrique de la couche de piégeage 3 peut être mesurée à différentes températures. A titre d'exemple, la densité de défauts prédéterminée pourra être comprise entre 10¹⁹ et 10²¹ cm⁻³ (par exemple, dans le cas d'une couche de piégeage en silicium polycristallin).

Dans le cas d'une densité de défauts suffisante dans la couche de piégeage 3 (ladite densité de défauts prédéterminée selon l'invention) corrélée avec une résistivité élevée, le mécanisme de conductivité dans la couche 3 est dominé par un régime de conductivité par sauts (« hopping conductivity » selon la terminologie anglo-saxonne). Cela permet de conserver un niveau de résistivité au dessus du seuil de 10kohm.cm, dans la gamme de température [-20°C ; +120°C]. L'homme du métier trouvera une présentation de la conductivité électrique par sauts dans le document « N.F.Mott, Phil. Mag, 19, 835, 1969 ».

Par « défaut », sans pour autant être limitatif, on entend des joints de grain dans les matériaux poly-cristallins, des zones de vide dans les matériaux poreux, des interstices, des inclusions...

De manière avantageuse, la couche de piégeage 3 comporte des microstructures de taille inférieure à 20nm ; de préférence, les microstructures ont même une taille inférieure à 10nm. Par « microstructures », on entend des cristallites, notamment pour les matériaux poly-cristallins, également appelés grains.

Ainsi, plus les microstructures sont petites dans la couche de piégeage 3, plus la densité de défauts dans celle-ci peut être importante.

De manière avantageuse, la couche de piégeage 3 présente également une résistivité supérieure à 10kohm.cm, à température ambiante ; préférentiellement, elle présente une résistivité supérieure à 50kohm.cm.

Les caractéristiques physiques (microstructure) et électriques (résistivité) précitées de la couche de piégeage 3 permettent d'assurer un mécanisme de conductivité par saut dans celle-ci, présentant une faible dépendance en fonction de la température ; la résistivité de la couche de piégeage 3 a de la même manière une faible dépendance avec la température, comparé à des couches de l'état de l'art, permettant de conserver un niveau supérieur à 10kohm.cm sur toute la gamme de températures visée.

L'épaisseur de la couche de piégeage 3 peut être comprise entre 10 et 50µm ; de préférence, elle est comprise entre 20 et 30µm. L'épaisseur de la couche de piégeage 3 est telle que les signaux RF issus des composants fabriqués sur la structure 1,1' pénètrent et se propagent majoritairement dans la couche de piégeage 3, sans atteindre le substrat support 2 sous-jacent. Les propriétés électriques de l'ensemble substrat support 2 et couche de piégeage 3 sont ainsi essentiellement dictées par les propriétés de la couche de piégeage 3. Les exigences sur la résistivité du substrat support 2 sont donc moindres. Dans le cas de substrats en silicium, le coût et la disponibilité de substrats dont la résistivité est dans la gamme 10-1000ohm.cm sont plus favorables que ceux de substrats à très haute résistivité (>1000ohm.cm et jusqu'à 20kohm.cm).

La couche de piégeage 3 présente également une faible différence de coefficient de dilatation thermique avec le substrat support 2 entre 100°C et 1200°C, avantageusement inférieure à 5ppm/K. En effet, la fabrication ultérieure de composants RF au-dessus de la couche de piégeage 3 nécessite généralement des étapes de traitements thermiques à des températures supérieures à 850°C, voire supérieures à 1100°C, par exemple 1200°C. A de telles températures, et pour des épaisseurs de couche de piégeage 3 de l'ordre de quelques dizaines de microns, une différence de coefficient d'expansion thermique trop importante entre la couche de piégeage 3 et le substrat support 2 peut provoquer des déformations incompatibles avec des procédés de fabrication ultérieurs, voire susceptibles de casser le substrat. Une différence de coefficient de dilatation thermique entre la couche de piégeage 3 et le substrat support 2 inférieure à 5ppm/K prévient les risques de casse de la structure.

La couche de piégeage 3 est avantageusement constituée de matériau poreux ou poly-cristallin. Selon un premier exemple, non limitatif, le substrat support 2 est un substrat de silicium et la couche de piégeage 3 est une couche de silicium poreux comprenant des microstructures de taille inférieure à 20 nm, présentant une porosité supérieure à 50% et une épaisseur de 30µm. La formation de la couche de silicium poreux comprend avantageusement les étapes suivantes :
- la formation d'une couche de silicium dopé p (bore par exemple) par épitaxie sur le substrat support, ladite formation étant exécutée par une technique de dépôt en phase vapeur, à une température comprise entre 900°C et 1200°C, avec comme précurseurs du trichlorosiliane et du diborane (B₂H₆) ;
- puis, une anodisation électrochimique.

La taille des microstructures confère à la couche de piégeage 3 une résistivité supérieure à 10kohm.cm, stable sur toute la gamme de température [-20°C ; 120°C]. Les pores de la couche de piégeage 3 ne sont pas affectés lors d'une étape de traitement thermique à haute température (typiquement jusqu'à 1100°C) : la taille des grains de la couche 3 régissant la résistivité de ladite couche 3, ses propriétés électriques restent inchangées après des traitements thermiques d'élaboration de composants.

Selon un deuxième exemple, non limitatif, le substrat support 2 est un substrat en silicium et la couche de piégeage 3 est une couche de silicium poly-cristallin comprenant des grains de taille inférieure à 20nm, de préférence inférieure à 10nm et présentant une épaisseur comprise entre 10 et 50 µm, par exemple 30 µm. La différence de coefficient d'expansion thermique entre le substrat support 2 et la couche de piégeage 3 est inférieure à 5 ppm/K, et prévient toute déformation excessive du substrat pouvant entrainer sa casse. La couche de piégeage 3 présente par ailleurs une résistivité supérieure à 50kOhm.cm à température ambiante.

Pour permettre à la couche de piégeage 3 de conserver ses caractéristiques physiques (microstructures) après l'application de traitements thermiques à hautes températures (nécessaires pour la fabrication ultérieures de composants RF), la couche de silicium poly-cristallin comprend avantageusement du carbone à une teneur comprise entre 1 et 20 %, par exemple 5 %. La réalisation d'une telle couche de piégeage 3 nécessite l'utilisation de techniques de dépôt chimique en phase vapeur. La température de formation de la couche doit alors être supérieure à 700°C, de préférence supérieure à 900°C, encore plus préférentiellement entre 1100 et 1200 °C. Les précurseurs de Carbone (C) peuvent comprendre au moins un des éléments choisi parmi : méthylsilane (SiH3CH3), méthane (CH4), éthane (C2H6), propane (C3H8), butane (C4H10), et méthyltrichlorosilane (SiCH3Cl3). Les précurseurs de Silicium (Si) peuvent comprendre au moins un des éléments choisi parmi : silane (SiH4), disilane (Si2H6), dichlorosilane (SiH2Cl2), trichlorosilane (SiHCl3), tétrachlorosilane (SiCl4).

Un dopage en carbone de la couche de poly-silicium permet de stabiliser la taille des grains lors d'un recuit thermique comprenant une montée en température supérieure à 850 °C, par exemple 1200 °C. En effet, sans ce dopage en carbone, les grains de la couche de piégeage 3 en poly-silicium se réorganisent et voient leur taille augmenter ; cela a pour conséquence de réduire drastiquement la résistivité de la couche de piégeage 3, et de dégrader ses caractéristiques électriques.

Lorsque qu'un dopage en carbone est introduit dans la couche de piégeage 3 en poly-silicium, les atomes de carbone se concentrent au niveau des joints de grains, et figent toute réorganisation des grains lors d'un recuit thermique comprenant une montée en température supérieure à 850°C. Par conséquent, les étapes de traitement thermique pour l'élaboration de composants n'affectent pas les propriétés physiques et électriques de la couche de piégeage 3.

La figure 2 représente la résistivité de la couche de piégeage 3 selon l'invention (courbe C) simulée sur la gamme de températures [20°C - 140°C] : on peut noter que la résistivité de ladite couche 3 est supérieure à 10kohm.cm, au moins jusqu'à 120°C, qui correspond à la borne supérieure de la gamme de températures visée. En comparaison, la résistivité simulée de structures de l'état de l'art (courbes A et B) présente des valeurs bien inférieures à 10kohm.cm à 120°C, ce qui n'autorise pas des performances RF suffisantes pour répondre aux spécifications exigeantes des normes LTE (Long Term Evolution) de la téléphonie mobile. Une structure 1,1',11 pour applications RF selon l'invention pourra quant à elle assurer une performance stable, non sensible aux variations de températures dans la plage d'utilisation.

Selon un premier mode de réalisation de l'invention, la structure 1 pour applications radiofréquences peut prendre la forme d'une plaquette de dimensions compatibles avec des procédés microélectroniques, par exemple de diamètre 200mm ou 300mm, comprenant le substrat support 2 et la couche de piégeage 3. Cette dernière pourra être élaborée selon le premier ou deuxième exemple cité précédemment, ces exemples de fabrication n'étant néanmoins pas exhaustifs.

Selon un deuxième mode de réalisation de l'invention, représenté sur la figure 3a, la structure 1' pour applications radiofréquences peut prendre la forme d'une plaquette et comporter en outre une couche active 5, disposée sur la couche de piégeage 3, dans et sur laquelle des composants RF pourront être élaborés. La couche active 5 pourra avantageusement être constituée de matériaux semi-conducteurs et/ou de matériaux piézoélectriques. Avantageusement, sans toutefois que cela soit limitatif, la couche active 5 comprend au moins l'un des matériaux parmi : silicium, carbure de silicium, silicium germanium, niobate de lithium, tantalate de lithium, quartz, nitrure d'aluminium. L'épaisseur de la couche active 5 pourra varier de quelques nanomètres (par exemple 10nm) à plusieurs dizaines de microns (par exemple 50µm) selon les composants à fabriquer.

A titre d'exemple, la couche active 5 est reportée sur un substrat support 2 comportant la couche de piégeage 3, par un des procédés de transfert de couches minces bien connus de l'homme du métier, parmi lesquels :
- le procédé Smart Cut™, basé sur une implantation d'ions légers d'hydrogène et/ou d'hélium dans un substrat donneur et un collage par exemple par adhésion moléculaire de ce substrat donneur sur la couche de piégeage 3, elle-même disposée sur le substrat support 2; une étape de détachement permet ensuite de séparer une couche mince superficielle du substrat donneur (la couche active), au niveau du plan de fragilisation défini par la profondeur d'implantation des ions. Des étapes de finition pouvant inclure des traitements thermiques à haute température confèrent enfin la qualité cristalline et de surface requise à la couche active 5. Ce procédé est particulièrement adapté pour la fabrication de couches actives minces, d'épaisseur comprise entre quelques nanomètres et environ 1,5µm par exemple pour les couches de silicium.
- le procédé Smart Cut suivi d'une étape d'épitaxie, permettant notamment d'obtenir des couches actives plus épaisses, par exemple de quelques dizaines de nm à 20µm.
- les procédés de collage direct et d'amincissements mécanique, chimique et/ou mécano-chimique ; ils consistent à assembler un substrat donneur par adhésion moléculaire sur la couche de piégeage 3, elle-même disposée sur le substrat support 2, puis à amincir le substrat donneur jusqu'à l'épaisseur souhaitée de couche active, par exemple par rodage (« grinding » selon la terminologie anglo-saxonne) et par polissage (CMP pour « chemical mechanical polishing »). Ces procédés sont particulièrement adaptés au report de couches épaisses, par exemple de quelques microns à plusieurs dizaines de microns, et jusqu'à quelques centaines de microns.

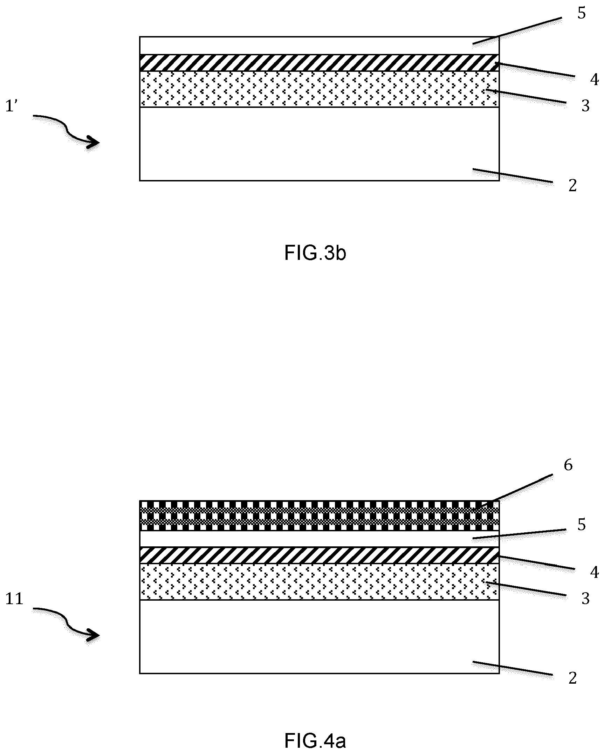

Selon une variante du deuxième mode de réalisation, représenté sur la figure 3b, la structure 1' pour applications radiofréquences pourra également comporter une couche diélectrique 4, disposée entre la couche active 5 et la couche de piégeage 3. Avantageusement, sans toutefois que cela soit limitatif, la couche diélectrique 4 comprendra au moins l'un des matériaux parmi : dioxyde de silicium, nitrure de silicium, oxyde d'aluminium... Son épaisseur pourra varier entre 10nm et 6µm.

La couche diélectrique 4 est obtenue par oxydation thermique ou par dépôt LPCVD ou PECVD ou HDP, sur la couche de piégeage 3 ou sur le substrat donneur préalablement au report de la couche active 5 sur la couche de piégeage 3.

Selon un troisième mode de réalisation, illustré sur la figure 4a, la structure 11 pour applications radiofréquences peut également comporter ou consister en un dispositif microélectronique 6 sur ou dans la couche active 5, laquelle est disposée sur une couche diélectrique 4 ou directement sur la couche de piégeage 3. Le dispositif microélectronique 6 peut être un circuit de commutation (appelé « switch » selon la terminologie anglo-saxonne), un circuit d'adaptation ou de syntonisation (appelé « tuner »), ou encore un circuit d'amplification de puissance (appelé « power amplifier »), élaboré selon les technologies microélectroniques silicium. La couche active 5 en silicium a typiquement une épaisseur comprise entre 50nm et 180nm, par exemple 145nm, et la couche diélectrique 4 sous-jacente a une épaisseur comprise entre 50nm et 400nm, par exemple 200nm ; la couche de piégeage 3 est disposée entre la couche diélectrique 4 et le substrat support 2. Le dispositif microélectronique 6 élaboré dans et sur la couche active 5 comprend une pluralité de composants actifs (de type MOS, bipolaire,...) et une pluralité de composants passifs (de type capacités, inductances, résistances, résonateurs, filtres, ...). La fabrication des composants microélectroniques nécessite la réalisation de plusieurs étapes dont des traitements thermiques à hautes températures, typiquement à 950-1100°C, voire au-delà. Les couches de piégeage 3 décrites dans les premier et deuxième exemples cités préalablement, conservent leurs propriétés physiques et électriques après de tels traitements thermiques.

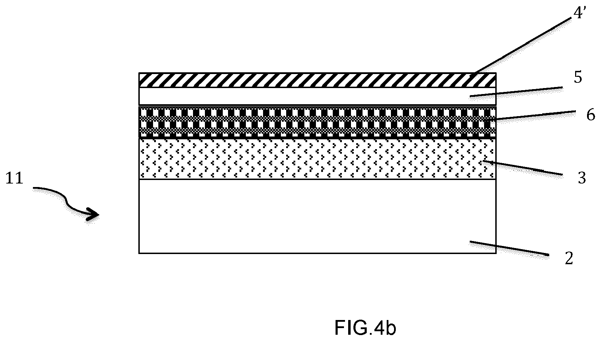

Selon une variante de ce mode de réalisation, le dispositif microélectronique 6 peut être d'abord élaboré sur un substrat de type SOI (pour « silicon on insulator » selon la terminologie anglo-saxonne), puis reporté par une technique de transfert de couches connue de l'homme du métier, sur une structure 1 selon l'invention comportant la couche de piégeage 3 disposée sur le substrat support 2. Dans ce cas, comme représenté sur la figure 4b, la structure 11 comprend le substrat support 2 sur lequel est disposée la couche de piégeage 3 ; au-dessus de cette dernière, se présente la couche de composants du dispositif microélectronique 6 : la partie dite « back end » de couches d'interconnexions métalliques et de diélectriques est disposée au-dessus de la couche de piégeage 3, la partie dite « front end » (silicium), élaborée en partie dans la couche active, étant elle-même au-dessus de la partie « back-end ». Enfin, on trouve encore au-dessus la couche active 5 et optionnellement une couche diélectrique 4'.

Dans les deux cas de figures, les champs électromagnétiques, issus des signaux hautes fréquences destinés à se propager dans les dispositifs 6, et qui vont pénétrer dans la couche de piégeage 3, ne subiront que de faibles pertes (pertes d'insertion) et perturbations (diaphonie, harmonique), du fait de la résistivité supérieure à 10kohm.cm de la couche de piégeage 3, et ce sur toute la gamme de température d'utilisation [-20°C ; 120°C].

Selon un quatrième mode de réalisation, la structure 11 pour applications radiofréquences peut comporter ou consister en un dispositif microélectronique 6 comprenant au moins un élément de commande et un élément de commutation MEMS (microsystèmes électromécaniques, soit « microelectromechanical systems » selon l'appellation anglo-saxonne) consistant en un microcommutateur à contact ohmique ou en un microcommutateur capacitif.

La fabrication de MEMS peut être facilitée par la présence d'une couche diélectrique 4 sous une couche active 5 de silicium. La structure 11 selon l'invention pourra donc comporter, à titre d'exemple, une couche active 5 en silicium d'épaisseur comprise entre 20 nm et 2000 nm, avantageusement 145 nm, et une couche diélectrique 4 sous-jacente d'épaisseur comprise entre 20 nm et 1000 nm, avantageusement 400 nm ; la couche de piégeage 3 est disposée entre la couche diélectrique 4 et le substrat support 2. La fabrication de la partie MEMS est ensuite basée sur des techniques de micro-usinage de surface, permettant en particulier la libération de poutres ou de membranes mobiles dans la couche active 5 de silicium.

De manière alternative et comme bien connu par l'homme du métier, la partie MEMS peut être élaborée directement sur la couche de piégeage 3, par dépôt successif d'une pluralité de couches (incluant une électrode, un diélectrique, une couche sacrificielle, une couche active) et par la réalisation de motifs sur ces différentes couches.

Les procédés microélectroniques permettant la fabrication du ou des éléments de commande (CMOS par exemple), habituellement réalisée avant la partie MEMS, requièrent, comme dans le mode de réalisation précédent, l'application de traitements thermiques à hautes températures. Le fait que la couche de piégeage 3 selon l'invention ne subisse pas de modifications physiques et électriques pendant ce type de traitement est donc très avantageux.

De la même manière que pour le troisième mode de réalisation, les signaux hautes fréquences se propageant dans ce dispositif génèrent des champs électromagnétiques qui pénètrent dans la couche de piégeage 3. Les pertes (pertes d'insertion), distorsions (harmoniques) et autres perturbations (diaphonie, ...) seront moindres du fait de la résistivité supérieure à 10kohm.cm de la couche de piégeage 3, sur toute la gamme de température visée d'utilisation du dispositif 6.

Selon un cinquième mode de réalisation, la structure 11 pour applications radiofréquences peut comporter ou consister en un dispositif microélectronique 6 comprenant un filtre radiofréquence fonctionnant par propagation d'onde acoustique de volume (appelé « BAW » pour « Bulk Acoustic Wave » selon l'appellation anglo-saxonne).

La fabrication d'un filtre BAW de type FBAR (pour « thin-Film Bulk Acoustic Resonator » selon la terminologie anglo-saxonne) nécessite une couche active 5 constituée d'un matériau piézoélectrique, dans laquelle sera confinée l'onde acoustique, entre les deux électrodes qui l'entourent. La structure 11 selon l'invention pourra donc comporter, à titre d'exemple, une couche active 5 de nitrure d'aluminium d'épaisseur comprise entre 50 nm et 1 µm, avantageusement 100 nm, et une couche diélectrique 4 (par exemple d'oxyde de silicium) dont l'épaisseur est comprise entre 1 et 6 µm ; la couche de piégeage 3 est disposée entre la couche diélectrique 4 et le substrat support 2. Des cavités d'isolation sont aménagées sous les zones actives du filtre, c'est-à-dire les zones dans lesquelles les ondes acoustiques seront amenées à se propager.

La fabrication du filtre BAW nécessite par ailleurs des étapes de dépôts d'électrodes au niveau desquelles sera appliqué le signal RF.

La structure selon l'invention permet d'une part de limiter la profondeur des cavités d'isolation dont la fonction d'isolation par rapport au substrat est rendue moins critique par la résistivité supérieure à 10kohm.cm de la couche de piégeage 3, sur toute la gamme de température visée ; c'est un avantage en terme de simplification, flexibilité et robustesse de procédé de fabrication de ces dispositifs. D'autre part, la structure 11 selon l'invention permet l'obtention de meilleures performances des filtres sur toute la gamme de température visée d'utilisation du dispositif 6, notamment en terme de linéarité.

Selon une variante de ce cinquième mode de réalisation, le dispositif microélectronique 6 comprend un filtre radiofréquence fonctionnant par propagation d'onde acoustique de surface (appelé « SAW » pour « Surface Acoustic Wave » selon l'appellation anglo-saxonne).

La fabrication d'un filtre SAW nécessite une couche active 5 constituée d'un matériau piézoélectrique, à la surface de laquelle sera élaboré un peigne d'électrodes : l'onde acoustique est destinée à se propager entre ces électrodes. La structure 11 selon l'invention pourra donc comporter, à titre d'exemple, une couche active 5 de tantalate de lithium d'épaisseur comprise entre 200 nm et 20 µm, avantageusement 0,6 µm ; la couche de piégeage 3 est disposée entre la couche active 5 et le substrat support 2. Une couche diélectrique 4 peut optionnellement être ajoutée entre la couche active 5 et la couche de piégeage 3.

La structure 11 selon l'invention permet l'obtention de meilleures performances de filtres, sur toute la gamme de température visée d'utilisation du dispositif 6, notamment en terme de pertes d'insertion et de linéarité.

Les structures 1,1',11 pour applications radiofréquences selon l'invention ne sont pas limitées aux modes de réalisation cités ci-dessus. Elles sont adaptées à toute application pour laquelle des signaux hautes fréquences se propagent et sont susceptibles de subir des pertes ou des perturbations non souhaitées dans un substrat support 2, car les caractéristiques physiques et électriques de la couche de piégeage 3 disposée sur le substrat support 2 confèrent à la structure 1,1',11 de bonnes propriétés RF (limitant les pertes, non-linéarités et autres perturbations), stables dans une gamme de températures d'utilisation, à savoir [-20°C ; 120°C].

## Revendications

1. Structure (1,1',11) pour des applications radiofréquences comprenant :
• un substrat support (2) semi-conducteur ;
• une couche de piégeage (3) disposée sur le substrat support (2) et comprenant une densité de défauts supérieure à une densité de défauts prédéterminée ;
la couche de piégeage (3) étant **caractérisée en ce que** :
• elle présente une résistivité électrique supérieure à 10kohm.cm à 20°C ;
• la densité de défauts prédéterminée est la densité de défauts pour laquelle le mécanisme de conductivité dans la couche de piégeage (3) est dominé par un régime de conductivité par sauts ;
• l'épaisseur de la couche de piégeage (3) est comprise entre 10 et 50 µm.

2. Structure (1,1',11) pour des applications radiofréquences selon la revendication 1, dans laquelle la couche de piégeage (3) présente une résistivité, à 20 °C, supérieure à 50 kOhm.cm.

3. Structure (1,1',11) pour des applications radiofréquences selon l'une des revendications précédentes, dans laquelle la différence de coefficient d'expansion thermique de la couche de piégeage (3) et du substrat support (2) est inférieure à 5 ppm/K entre 100°C et 1200°C.

4. Structure (1,1',11) pour des applications radiofréquences selon l'une des revendications précédentes, dans laquelle la couche de piégeage (3) comprend des microstructures de taille inférieure à 20 nm, de préférence inférieure à 10 nm.

5. Structure (1,1',11) pour des applications radiofréquences selon l'une des revendications précédentes, dans laquelle la couche de piégeage (3) comprend un matériau poreux ou poly cristallin.

6. Structure (1,1',11) pour des applications radiofréquences selon l'une des revendications précédentes, dans laquelle la couche piégeage (3) comprend du silicium poly-cristallin comprenant 1 à 20 % de carbone.

7. Structure (1,1',11) pour des applications radiofréquences selon l'une des revendications précédentes, dans laquelle l'épaisseur de la couche de piégeage (3) est comprise entre 20 et 30 µm.

8. Structure (1,1',11) pour des applications radiofréquences selon l'une des revendications précédentes, dans laquelle le substrat support (2) comprend au moins un des matériaux sélectionné dans le groupe suivant: silicium, silicium germanium, carbure de silicium.

9. Structure (1,1',11) pour des applications radiofréquences selon l'une des revendications précédentes, dans laquelle la résistivité du substrat support (2) est comprise entre 10 et 2000 Ohm.cm.

10. Structure (1,1',11) pour des applications radiofréquences selon l'une des revendications précédentes, dans laquelle une couche active (5) est disposée sur la couche de piégeage (3).

11. Structure (1,1',11) pour des applications radiofréquences selon la revendication 10, dans laquelle la couche active (5) est formée à partir d'un matériau semi-conducteur.

12. Structure (1,1',11) pour des applications radiofréquences selon la revendication 10, dans laquelle la couche active (5) est formée à partir d'un matériau piézoélectrique.

13. Structure (1,1',11) pour des applications radiofréquences selon l'une des revendications 10 à 12, dans laquelle l'épaisseur de la couche active (5) est comprise entre 10 nm et 50 µm.

14. Structure (1,1',11) pour des applications radiofréquences selon l'une des revendications 10 à 13, dans laquelle une couche diélectrique (4) est disposée entre la couche de piégeage (3) et la couche active (5).

15. Structure (1,1',11) pour des applications radiofréquences selon la revendication 14, dans laquelle la couche diélectrique (4) est comprise entre 10 nm et 6 µm.

16. Structure (1,1',11) pour des applications radiofréquences selon l'une des revendications 10 à 15, dans laquelle au moins un dispositif microélectronique est présent sur ou dans la couche active (5), le dispositif microélectronique étant un circuit de commutation ou un circuit d'adaptation d'antenne ou un circuit d'amplification de puissance radiofréquences.

17. Structure (1,1',11) pour des applications radiofréquences selon l'une des revendications 10 à 16, dans laquelle au moins un dispositif microélectronique est présent sur ou dans la couche active (5), le dispositif microélectronique comprenant une pluralité de composants actifs et une pluralité de composants passifs.

18. Structure (1,1',11) pour des applications radiofréquences selon l'une des revendications 10 à 16, au moins un dispositif microélectronique est présent sur ou dans la couche active (5), le dispositif microélectronique comprenant au moins un élément de commande et un élément de commutation MEMS consistant en un micro-commutateur à contact ohmique ou en un micro-commutateur capacitif.

19. Structure (1,1',11) pour des applications radiofréquences selon la revendication 10 à 15, dans laquelle au moins un dispositif microélectronique est présent sur ou dans la couche active (5), le dispositif microélectronique étant un filtre radiofréquence fonctionnant par propagation d'ondes acoustiques de volume ou de surface.
